# EUROPÄISCHE PATENTSCHRIFT

(11) **EP 0 554 916 B1**
(45) Veröffentlichungstag und Bekanntmachung des Hinweises auf die Patenterteilung: **06.08.1997**
(21) Anmeldenummer: 93103992.9
(22) Anmeldetag: 21.10.1987
(51) Int. Cl.: G06K 19/077

(54) **Baustein mit integrierten Schaltkreisen**
Module with integrated circuits
Module de circuit intégré

(30) Priorität: 20.11.1986 DE 3639630
(43) Veröffentlichungstag der Anmeldung: 11.08.1993
(62) Teilanmeldung aus: 87115451.4
(73) Patentinhaber: GAO Gesellschaft für Automation und Organisation mbH, 81307 München (DE)
(72) Erfinder: Haghiri, Yahya, Dipl.-Ing., W-8000 München 40 (DE)
(74) Vertreter: Klunker . Schmitt-Nilson . Hirsch

(56) Entgegenhaltungen:
- EP-A- 0 197 438
- EP-A- 0 198 376
- PATENT ABSTRACTS OF JAPAN, Band 7, Nr. 276 (E-215), 1983; & JP - A - 58155747 (KIYOUDOU INSATU K.K.)

## Beschreibung

Die Erfindung betrifft einen Datenträger mit mindestens einem IC-Baustein zur Verarbeitung elektrischer Signale, wobei der IC-Baustein auf einem im Vergleich zur Fläche des Datenträgers kleinen Substrat angeordnet ist, über Leiterbahnen mit ebenfalls auf dem Substrat vorgesehenen Kontaktelementen, die die Kommunikation des IC-Bausteins mit entsprechenden Automaten ermöglichen, in Verbindung steht und in einer Aussparung einer mittleren Kartenschicht angeordnet ist.

Ein Datenträger der o.g. Art ist beispielsweise aus der DE-OS 33 38 597 bekannt.

Bei dem bekannten Datenträger wird das den IC-Baustein, die Leiterbahnen und die Kontaktflächen tragende Substrat derart unter Anwendung von Wärme und Druck in eine mehrschichtige Ausweiskarte einlaminiert, daß der IC-Baustein im Inneren der Karte liegt, während die Kontaktflächen mit der Kartenoberfläche bündig abschließen.

Die in der DE-OS 33 38 597 verwendete Bauform für den integrierten Schaltkreis ist ein sogenanntes Mikropack. Das Substrat besteht dabei im allgemeinen aus einem Material (z. B. Polyimid), das sich mit den üblichen Kartenmaterialien nicht verbindet. Es wird daher ein Schmelzkleber bzw. eine Schmelzkleberfolie eingesetzt, um die unterschiedlichen Kunststoffmaterialien unter Anwendung von Wärme und Druck miteinander verbinden zu können.

Wenn auch die in der DE-OS 33 38 597 erwähnte Schmelzkleberfolie als nachgiebige weiche Schicht in Form einer Pufferzone eine für den Schaltkreis schützende Wirkung aufbringt, hat sich doch in der Praxis gezeigt, daß diese schützende Wirkung vor allem bei integrierten Schaltkreisen mit größeren Abmessungen, die aufgrund ihrer Abmessungen beim Kartengebrauch stärkeren Biegekräften ausgesetzt sind, nicht den gewünschten Erfordernissen entspricht. Dies ist unter anderem auch darauf zurückzuführen, daß die Schmelzkleberfolie vergleichsweise dünn ausgebildet sein muß, wodurch die schützende Wirkung als Pufferzone zwangsläufig eingeschränkt wird. Bei dickeren Folien kann nämlich nicht vermieden werden, daß während des Zusammenpressens der Kartenschichten an den Randbereichen des Substrats Schmelzklebermaterial austritt, an die Oberfläche der Karte gelangt und das Erscheinungsbild der Karte beeinträchtigt, wenn es nicht in einem zusätzlichen Verfahrensschritt entfernt wird. Die Schmelzkleberfolie wird also in ihrer Dicke derart optimiert, daß bei guter Haftung, bezogen auf die gesamte Fläche des Substrats, kein Klebermaterial an den offenen Stellen im Randbereich des Substrats austritt. Damit bleibt aber bei vertretbarem technischen Aufwand kein Spielraum hinsichtlich der Optimierung der Schmelzkleberfolie als schützende Pufferzone.

Ein weiterer Datenträger dieses Arts ist aus EP-A-0 198 376 bekannt. Diese zeigt, wie die Anschlußpunkte eines integrierten Schaltkreises üblicherweise auf der Kontaktfläche angeordnet sind, nämlich weitgehend dezentral.

Die Aufgabe der Erfindung besteht deshalb darin, ohne nennenswerten technischen Mehraufwand einen Datenträger mit integriertem Schaltkreis vorzuschlagen, bei dem auch Schaltkreise mit größeren Abmessungen den mechanischen Beanspruchungen in der Praxis standhalten.

Gelöst wird diese Aufgabe durch die im Bauptanspruch angegebenen Merkmale.

Die einzelnen Schichten eines Datenträgers und das den IC-Baustein tragende Substrat werden unter Anwendung von Wärme und Druck miteinander verpreßt. Dabei wird das den IC-Baustein, die Leiterbahnen und die Kontaktflächen tragendes Substrat derart in das Laminat eingebettet, daß der IC-Baustein im Inneren des Datenträgers angeordnet ist, während die Kontaktflächen an dessen Oberfläche liegen. Um das Substrat mit den Materialien des Datenträgers verbinden zu können, wird eine Schmelzkleberfolie eingesetzt. Zusätzlich ist nun als separates Element zwischen dem Substrat und der Schmelzkleberfolie ein Folienstreifen vorgesehen, der etwa die Breite und mindestens die Länge des IC-Bausteins hat und der aus einem Material besteht, das ein gegenüber dem umgebenden Materialien des Datenträgers höheres Deformierungsvermögen aufweist.

Mit dem Einsatz dieses Folienstreifens wird es möglich, auch für Schaltkreise mit größeren Abmessungen eine wirksame Pufferzone vorzusehen, ohne die Dicke der Schmelzkleberfolie an die Größe des Bausteins anpassen zu müssen. Schmelzkleberfolie und der die schützende Pufferzone bildende Folienstreifen können unabhängig voneinander im Hinblick auf ihre jeweiligen Funktionen optimiert werden. Während die Schmelzkleberfolie derart gewählt wird, daß bei guter Haftung der zu verbindenen Elemente kein Klebermaterial an den offenen Stellen im Randbereich des Substrats austritt, kann der Folienstreifen als separat eingesetztes Element in seinen Abmaßen und physikalischen Eigenschaften derart optimiert werden, daß auch größere IC-Bausteine gegenüber mechanischen Belastungen wirksam geschützt sind.

Trotz dieser Vorteile ist der Einsatz des Folienstreifens mit keinem nennenswerten Mehraufwand verbunden. Die zum Einbau in Ausweiskarten geeigneten integrierten Schaltkreise werden im allgemeinen auf Filmstreifen montiert vom Halbleiterhersteller geliefert. Um aus dem Filmstreifen entsprechend ausgestanzte Substrate, wie in der DE-OS 33 38 597 beschrieben, in Ausweiskarten einbauen zu können, ist, wie erwähnt, eine Klebeschicht, beispielsweise eine Schmelzkleberfolie erforderlich. Die Verbindung von Substrat und Schmelzkleberfolie geschieht vorzugsweise vor der Kartenherstellung, wobei beispielsweise in einer Rollen-Kaschiereinrichtung Substrat und Schmelzkleberfolie, jeweils von einer eigenen Rolle abgewickelt, zusammengeführt werden und unter Einwirkung von Wärme und Druck miteinander verbunden werden. Verfahrenstechnisch gesehen erfordert die Anordnung eines zusätzlichen Folienstreifens auf dem IC-Baustein keinen zusätzlichen Aufwand, da dieser Streifen, ebenfalls von einer Rolle abgewickelt, gleichzeitig mit der Schmelzkleberfolie auf den Substratfilm, der den integrierten Baustein trägt, aufgebracht werden kann. Der zusätzliche Folienstreifen wird zwischen Substrat und Schmelzkleberberfolie eingeschlossen. Auch der zusätzliche Materialaufwand bezogen auf ein Substrat bzw. auf einen Datenträger ist unter Berücksichtigung der Gesamtkosten eines Datenträgers praktisch ohne Bedeutung.

Bevorzugt besteht der Folienstreifen aus einem Material, das neben einem hohen elastischen Deformierungsvermögen eine gegenüber den Materialien des Datenträgers niedrigere Erweichungstemperatur aufweist und sich außerdem während des Laminiervorgangs mit den in der Umgebung befindlichen Materialien (wie beispielsweise Schmelzkleberfolie, Substratfolie und auch IC-Baustein) nicht verbindet. Da also der Folienstreifen während des Laminierens plastisch deformierbar ist und keine Verbindung mit den ihn umgebenden Materialien eingeht, können IC-Baustein und Leiterbahnen einerseits verspannungsfrei eingebettet werden und sich andererseits bei starken Deformationen des Datenträgers bei Gebrauch innerhalb des Laminats in gewissen Grenzen bewegen und somit den durch die Deformation bedingten Verspannungen im Laminat ausweichen. Ein Material, das die genannten Eigenschaften aufweist, ist beispielsweise Polyäthylen.

Es zeigen:
- Fig. 1: eine Ausweiskarte in der Aufsicht,
- Fig. 2: die Ausweiskarte nach Fig. 1 in einer Schnittdarstellung vor dem Laminieren,
- Fig. 3: die Ausweiskarte nach Fig. 1 in einer Schnittdarstellung nach dem Laminieren,
- Fig. 4: eine Vorrichtung zur Herstellung eines Trägerelements mit Folienstreifen,
- Fig. 5: eine Schnittdarstellung der Vorrichtung aus Fig. 4 entlang der Linie A-B,
- Fig. 6: die in der Vorrichtung gemäß Fig. 4 hergestellten Trägerelemente in der Aufsicht,
- Fig. 7: eine weitere Ausbildung eines in der Vorrichtung gemäß Fig. 4 hergestellten Trägerelements,
- Fig. 8: eine Ausweiskarte und ein Trägerelement vor dem Zusammenfügen der Einzelelemente,
- Fig. 9 und 10: ein Trägerelement in der Aufsicht und im Schnitt.

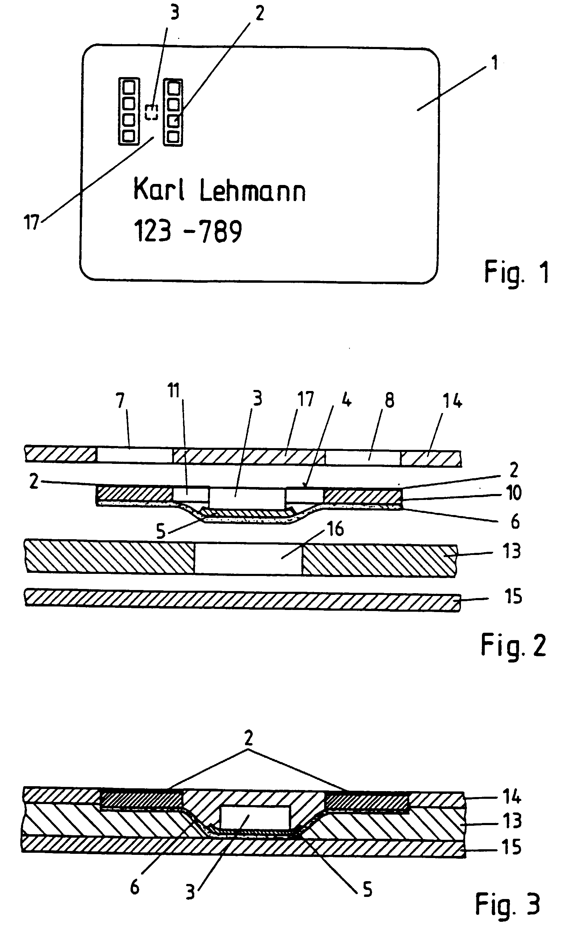

Die Fig. 1 zeigt eine Ausweiskarte 1 mit einem im Kartenkern eingebetteten IC-Baustein 3, der über Leiterbahnen mit den äußeren Kontaktflächen 2, die an der Oberfläche der Karte liegen, elektrisch verbunden ist. In einer bevorzugten Ausführungsform besteht die Karte aus drei Schichten (siehe Fig. 2 und 3), einer Kartenkernschicht 13, mit einer öffnung 16 für den IC-Baustein 3 und zwei Deckfolien 14, 15, wobei die Deckfolie 14 zwei Aussparungen 7 und 8 aufweist. Die Aussparungen sind so dimensioniert, daß sie in dem gezeigten Ausführungsbeispiel jeweils eine Gruppe, bestehend aus vier Kontaktflächen, aufnehmen können. Die untere Deckfolie 15 schließt die Ausweiskarte rückseitig ab. Zwischen der Kernschicht 13 und der Deckfolie 14 befindet sich das sogenannte Trägerelement, bestehend aus dem IC-Baustein 3, den Leiterbahnen 4, den Kontaktflächen 2 und dem Trägersubstrat 10. Der IC-Baustein 3 ist in einer Aussparung 11 des Substrats 10 mit den in die Aussparung hineinragenden Enden der Leiterbahnen 4 verbunden und wird in dem Fenster lediglich durch die Befestigung der Leiterbahnen mit den entsprechenden Anschlußpunkten des Bausteins gehalten. Diese Art der Befestigung bzw. Positionierung von Halbleiterbauelementen mit Leiterbahnen, die aus einer leitenden Beschichtung des Substrats geätzt sind, ist seit langem bekannt und hat sich in der Praxis bewährt (siehe dazu auch Siemens-Bauteile-Report 16 (1978), Heft 2, Seite 40 - 44).

Zur Fixierung des Trägerelements im Kartenaufbau ist das Trägerelement mit einer Schmelzkleberfolie 6 unterlegt. Diese Schmelzkleberfolie dient zur Verbindung des Substrats 10, das z. B. aus Polyimid besteht, mit dem Material der Ausweiskarte (beispielsweise PVC), so daß sich diese Schichten während des Zusammenpressens unter Wärme und Druck miteinander verbinden.

Ferner wird zwischen der Schmelzkleberfolie 6 und dem IC-Baustein 3 ein Folienstreifen 5 eingebracht, der mindestens die Abmaße des IC-Bausteins aufweist und dessen Bodenfläche abdeckt. Der Folienstreifen besteht aus einem Material mit hohem elastischen Deformierungsvermögen, so daß sich IC-Baustein und Leiterbahnen auch bei starken Deformationen der Karte innerhalb des Kartenlaminats in gewissen Grenzen bewegen und den durch die Deformation bedingten Verspannungen im Kartenlaminat ausweichen. Vorzugsweise hat das Material des Folienstreifens neben dem hohen elastischen Deformierungsvermögen einen gegenüber den eingesetzten Kartenmaterialien geringen Erweichungspunkt. Dadurch ist das Material während des Laminierens plastisch deformierbar, was eine verspannungsfreie Einbettung von IC-Baustein und Leiterbahnen ermöglicht. Es hat sich außerdem gezeigt, daß die Schutzwirkung noch verbessert werden kann, wenn man ein Material wählt, z. B. Polyäthylen, das nicht nur ein, z. B. gegenüber PVC, geringes Elastizitätsmodul E (PE) = 200 - 300 N/mm², E (PVC) = 3000 N/mm² und einen geringeren Erweichungspunkt aufweist, sondern sich auch während des Laminiervorgangs mit den in der Umgebung vorhandenen Materialien wie Schmelzkleberfolie 6, Substrat 10 und auch IC-Baustein 3 nicht verbindet. Die hierdurch noch verbesserte Schutzwirkung für den Schaltkreis ist vermutlich auf die Beweglichkeit des Folienstreifens im Karteninnern zurückzuführen, die nicht durch Haftwirkung zu benachbarten Elementen beeinträchtigt wird.

Die beschriebene, vorteilhafte Einbettungstechnik ist ohne nennenswerten technischen Mehraufwand realisierbar, wenn das Trägerelement bereits vor seiner Einlagerung in eine Ausweiskarte mit einem Folienstreifen ausgestattet wird.

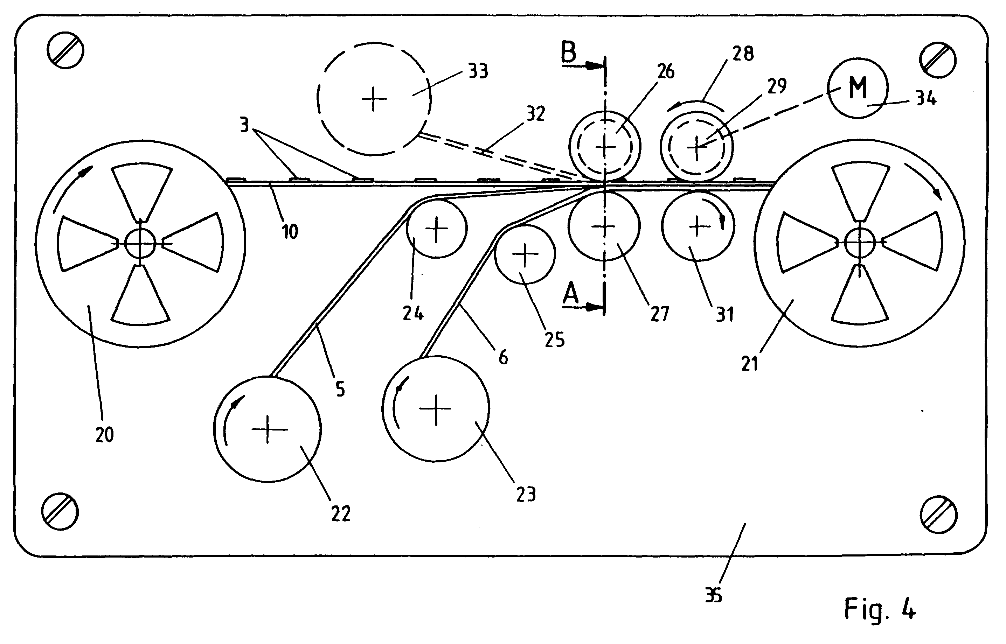

Eine entsprechende Vorrichtung zur Herstellung solcher Trägerelemente zeigt die Fig. 4. Die hier in stark schematisierter Form gezeigte Vorrichtung umfaßt im wesentlichen eine sogenannte Rollenkaschiereinrichtung, bestehend aus einer Heizwalze 26 und einer Andruckwalze 27 sowie einer Antriebseinrichtung, bestehend aus einer mit einem Motor 34 verbundenen Antriebswalze 29 und einer Gegenwalze 31. Der Motor dreht die Antriebswalze 29 in Richtung des Pfeils 28. Die zu verbindenden Film- bzw. Folienstreifen werden von Vorratsrollen 20, 22, 23 abgewickelt und nach dem Passieren der Rollenkaschier- und Antriebseinrichtung auf eine Speicherrolle 21 aufgewickelt. Diese und weitere im einzelnen noch später erläuterte Elemente sind alle auf einer Montageplatte 35 befestigt.

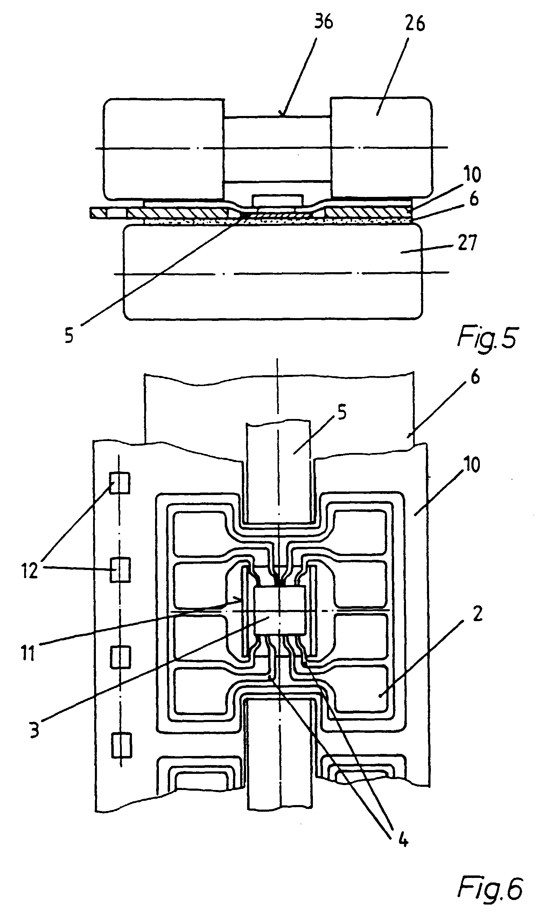

Das Ausgangsprodukt für die Herstellung von Trägerelementen ist ein Substratfilm 10, auf dem in regelmäßigen Abständen, in sogenannter TAB-Technik (Tape Automated Bonding), IC-Bausteine 3 montiert sind. Der mit den IC-Bausteinen 3 bestückte Film 10 ist, wie allgemein üblich, auf einer Rolle 20 aufgewickelt. Die Schmelzkleberfolie 6 wird von einer Vorratsrolle 23 über eine Umlenkrolle 25 gemeinsam mit dem Substratfilm 10 zwischen Heiz- und Andruckwalze 26, 27 geführt. Zwischen der Heizwalze 26 und der Andruckwalze 27 wird die Schmelzkleberfolie 6 unter Einwirkung von Wärme und Druck mit dem Substratfilm 10 verbunden. Wie die Fig. 5 in einer Schnittdarstellung zeigt, ist die Heizwalze 26 mittig mit einer umlaufenden Aussparung 36 versehen, so daß beim Durchlauf des mit den IC-Bausteinen 3 bestückten Substratfilms 10 die Bausteine frei von mechanischen und thermischen Belastungen sind. Die Schmelzkleberfolie 6 wird dabei entlang der in Transportrichtung verlaufenden Randbereiche mit dem Substratfilm 10 verbunden. Der zwischen dem IC-Baustein und der Schmelzkleberfolie 6 eingelagerte Folienstreifen 5 wird von einer Vorratsrolle 22 abgewickelt und über die Umlenkrolle 24 im Bereich von Heiz- und Gegendruckwalze zwischen Schmelzkleberfolie 6 und Substratfilm 10 geführt. Dieser Folienstreifen wird nicht mit den umgebenden Materialien verbunden, sondern lediglich durch den Verbund von Schmelzkleberfolie 6 und Substratfilm 10 in der durch die Einführung vorgegebenen Lage eingeschlossen. Das Folienlaminat durchläuft nach dem Verschmelzen die Antriebs- und Gegendruckwalze 29, 31. Hier wird die Schmelzkleberfolie nochmals unter gleichzeitiger Abkühlung an den Substratfilm angepreßt und damit endgültig fixiert. Das fertiggestellte Laminat wird schließlich auf die Speicherrolle 21 aufgewickelt.

Das Endprodukt ist in der Fig. 6 in der Aufsicht dargestellt. Die Fig. zeigt den Substratfilm 10 mit an seiner Oberfläche liegenden Kontaktflächen 2 und den Leiterbahnen 4, die zu dem in einer Aussparung liegenden IC-Baustein 3 führen. Längs einer Seitenkante ist der Substratfilm 10 mit Perforationslöchern 12 versehen, die auch in der oben beschriebenen Vorrichtung benutzt werden können, um den Substratfilm 10 während der einzelnen Bearbeitungsvorgänge exakt zu transportieren. Der Fig. 6 sind die Abmessungen sowie die Lage des zwischen der Schmelzkleberfolie 6 und dem Substratfilm 10 eingelagerten Folienstreifens 5 zu entnehmen. Der Folienstreifen 5 hat etwa die Breite des IC-Bausteins und erstreckt sich aber über die gesamte Länge des Substratfilms 10. Vorzugsweise werden die zum IC-Baustein 3 in die Aussparung 11 verlaufenden Leiterbahnen 4 derart geführt, daß sie ebenfalls auf dem durchlaufenden Folienstreifen 5 liegen und damit entsprechend geschützt sind.

Wie gezeigt, kann der den IC-Baustein 3 sowie die Leiterbahnen 4 schützende Folienstreifen 5, verfahrenstechnisch gesehen, ohne Mehraufwand zwischen Schmelzkleberfolie 6 und Substratfilm 10 plaziert werden.

Bei der in der Fig. 1 bzw. in der Fig. 3 gezeigten Ausweiskarte werden die einzelnen Kartenschichten unter Anwendung von Wärme und Druck miteinander verbunden. Während des Laminierprozesses wird das Substrat mit allen Bauteilen derart in das Kartenlaminat eingelagert, daß der IC-Baustein etwa in der Mitte des Kartenlaminats liegt, während die Kontaktflächen bündig mit der Kartenoberfläche abschließen. Der zwischen den Kontaktbereichen verlaufende Steg 17 aus dem Material der Deckfolie 14 sorgt u. a. dafür, wie auch in der DE-OS 33 38 597 beschrieben, daß der IC-Baustein in die Aussparung 16 der Kernschicht 13 gedrückt wird.

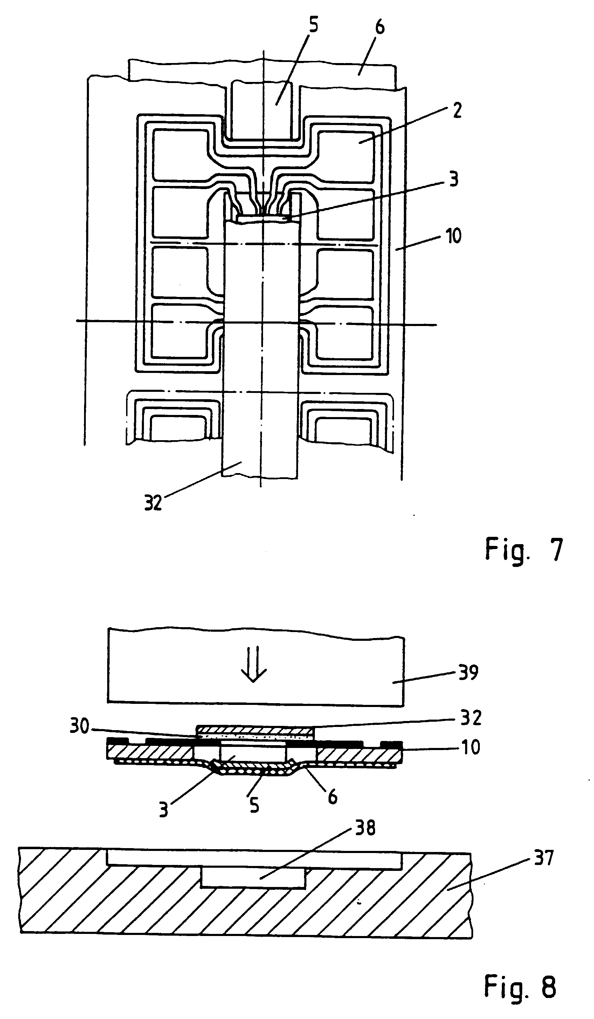

Gemäß anderer bekannt gewordener Einbautechniken wird das Substrat beispielsweise in eine vorbereitete Aussparung einer fertiggestellten Ausweiskarte eingesetzt. Da in diesem Fall keine weitere Deckschicht vorgesehen ist, muß, sofern die sogenannte Mikropack-Bauform beibehalten werden soll, das Substrat auf der Seite, auf der sich die Kontaktflächen befinden, im Bereich des IC-Bausteins auf andere Weise abgedeckt und damit geschützt werden. Eine weitere Ausführungsform der Erfindung besteht deshalb darin, mittig auf dem Substrat 10, wie in Fig. 7 und 8 gezeigt, einen Folienstreifen 32 aufzubringen. Auch dieser Folienstreifen kann ähnlich dem oben geschilderten Verfahren auf einfache Weise mit der in der Fig. 4 gezeigten Vorrichtung auf das Substrat aufgebracht werden. Dazu ist lediglich eine weitere Vorratsrolle 33 vorzusehen (in der Fig. 4 strichliert gezeichnet), von der ein entsprechender Folienstreifen 32 abgewickelt und zwischen Heiz- und Andruckwalze 26, 27 geführt wird. Zur Befestigung des Folienstreifens 32 auf der Substratfolie 10 kann dieser mit einer Klebeschicht 30 versehen werden. Der Folienstreifen 32 wird vorzugsweise dem jeweiligen Kartenmaterial angepaßt, besteht also beispielsweise aus PVC, das entsprechend dem jeweiligen Kartendesign eingefärbt oder bedruckt ist.

Zum Einbau des letztgenannten Substrats in eine Ausweiskarte wird die fertiggestellte Karte (37) mit einer Aussparung 38 versehen, die den Abmessungen des Substrats angepaßt ist (Fig. 8). Das Substrat wird beispielsweise mit einem Heizstempel 39 mit dem Kartenkörper 37 verbunden. Durch den mittig das Substrat durchziehenden Folienstreifen 32 ruht der IC-Baustein gegen äußere Einflüsse geschützt in der Mitte des Kartenkörperlaminats, während die Kontaktflächen offen zugängig an der Kartenoberfläche liegen.

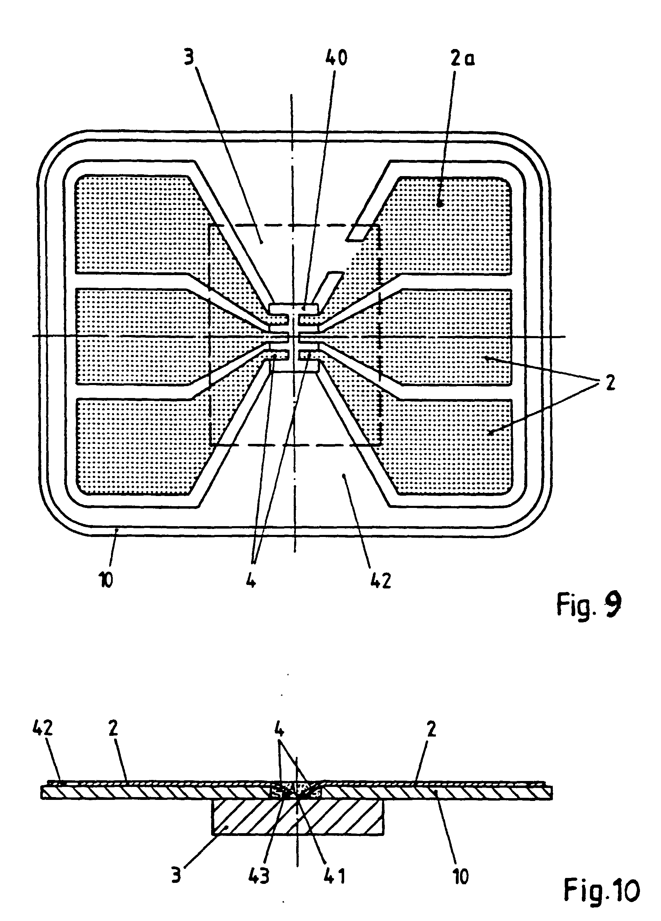

Die Fig. 9 und 10 zeigen schließlich eine Ausführungsform eines Trägerelements für integrierte Schaltkreise, welches im wesentlichen dadurch gekennzeichnet ist, daß die Anschlußpunkte 43 des integrierten Schaltkreises 3 nicht, wie üblich gezeigt, im Randbereich der Chipfläche liegen.

Bei dem in den Fig. 11 und 12 beispielhaft gezeigten Trägerelement liegen die Anschlußpunkte 43 des Schaltkreises, auf die die Enden der Leiterbahnen 4 durch eine Aussparung 40 in der Folie 10 geführt sind, im Zentrum der Schaltkreisfläche. Dies hat mehrere Vorteile.

Das Ausfüllen des Hohlraums 40 mit einem geeigneten Harz oder Silikon ist technisch einfacher zu handhaben, weil der zu füllende Hohlraum in seinem Volumen in nur engen Toleranzen variiert.

Drückt man während des Füllens den Schaltkreis gegen den Film 10, so daß der Schaltkreis die Aussparung 40 einseitig abschließt, liegt ein in seinem Volumen definierter Hohlraum 40 vor, der bei einmal eingestellter Dosierung im Fertigungsprozeß auf einfache Weise gleichmäßig gefüllt werden kann. Auch ein geringer Spalt zwischen Schaltkreis und Film, der während des Füllvorgangs ebenfalls mit dem gewählten Harz oder Silikon ausgefüllt wird, hat auf die Dosierung keinen nachteiligen Einfluß, da die hier einfließende Menge gering ist und bei verschiedenen Trägerelementen nur unwesentlich variiert.

Wählt man zum Ausfüllen des Hohlraums ein transparentes Harz oder Silikongel, dann stört auch ein möglicherweise unregelmäßiger Abschluß der Aussparung an der Oberfläche des Trägerelements nicht das Erscheinungsbild.

Die in den Fig. 9 gezeigte Anordnung der Anschlußpunkte 43 des Bausteins 3 hat weiterhin den Vorteil, daß die gelöteten oder geschweißten Verbindungen zwischen den Leiterbahnenden 4 und den Anschlußpunkten 43 des Bausteins aufgrund ihrer zentralen Lage bei Verbiegungen des Trägerelements bezüglich etwaiger Zug- oder Schwerkräfte mechanisch geringer belastet werden, als bei dezentraler Anordnung der Anschlußpunkte im Randbereich des Schaltkreises.

Schließlich hat die gezeigte Plazierung der Anschlußpunkte 43 auf den Schaltkreis den Vorteil, daß die Leiterbahnführung und damit auch das Bondwerkzeug bei unterschiedlicher Schaltkreisgröße unverändert beibehalten werden kann.

## Patentansprüche

1. IC-Baustein mit integrierten Schaltkreisen, Leiterbahnen und Anschlußpunkten, die mit Hilfe geeigneter Verbindungstechniken mit weiterführenden Leiterbahnen zur Kommunikation mit dem Schaltkreis verbunden werden, dadurch **gekennzeichnet,** daß die Anschlußpunkte (43) des Bausteins (3) in wenigstens einer Gruppe zusammengefaßt in einem inneren Bereich der Kontakttragenden Grundfläche des Bausteins (3) angeordnet sind, so daß der Abstand jedes der Anschlußpunkte zur Mitte der Grundfläche geringer als zum Rand der Grundfläche ist.

## Claims

1. An IC module having integrated circuits, leads and terminals which are connected by suitable connecting techniques with further leads for communication with the circuit, characterized in that the terminals (43) of the module (3) are combined in at least one group and disposed in an inner region of the contact-bearing base of the module (3) so that the distance of each of the terminals from the center of the base is smaller than from the edge of the base.

## Revendications

1. Module de CI comprenant des circuits intégrés, des pistes conductrices et des points de connexion qui sont reliés à l'aide de techniques de raccordement appropriées à des pistes conductrices de continuation pour la communication avec le circuit, caractérisé en ce que les points de connexion (43) du module (3) sont disposés rassemblés en au moins un groupe dans une zone intérieure de la surface de base supportant les contacts du module (3) de façon que l'espacement de chacun des points de connexion au milieu de la surface de base soit plus petit qu'au bord de la surface de base.
